(19) Europäisches Patentamt
European Patent Office
Office européen des brevets

(11) **EP 4 769 070 A1**

(12) **EUROPEAN PATENT APPLICATION**

(43) Date of publication:
**01.07.2026 Bulletin 2026/27**

(21) Application number: **25152797.4**

(22) Date of filing: **20.01.2025**

(51) International Patent Classification (IPC):
**G06F 1/28** (2006.01)      **G06F 1/30** (2006.01)
**G06F 1/3212** (2019.01)      **G06F 11/00** (2006.01)
**G06F 11/22** (2006.01)      **G01R 31/389** (2019.01)

(52) Cooperative Patent Classification (CPC):
**G06F 1/30; G01R 31/389; G06F 1/28; G06F 1/3212**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **30.12.2024 US 202419006157**

(71) Applicant: **MediaTek Inc.**
**Hsinchu City, 30078 (TW)**

(72) Inventors:
• LIAO, Chi-Cheng
  Hsinchu City 30078 (TW)
• CHUANG, Jia-You
   Hsinchu City 30078 (TW)
• WU, Jui-Chi
  Hsinchu City 30078 (TW)

(74) Representative: **Hoefer & Partner Patentanwälte mbB**
**Pilgersheimer Straße 20**
**81543 München (DE)**

(54) **POWER CONTROL METHOD FOR GENERATING A MINIMUM BOOT-UP VOLTAGE OF A SYSTEM**

(57)    A power control method includes measuring an internal resistance of a battery of the system (S210), measuring a maximum boot-up current of the system (S220), generating a voltage drop according to the internal resistance and the maximum boot-up current (S230), generating a minimum boot-up voltage according to a predetermined voltage and the voltage drop (S240), and performing a boot-up process using a setting with the minimum boot-up voltage where the battery is charged to at least the minimum boot-up voltage in the boot-up process (S250).

FIG. 2

## Description

### BACKGROUND

For a system, there is a minimum boot-up voltage, and a battery in the system should be charged to the minimum boot-up voltage before the system can be booted successfully. Otherwise, the system will reboot repeatedly and fail to complete the boot-up process. This minimum boot-up voltage is not a fixed voltage. As the battery ages and/or the external environment changes, the minimum boot-up voltage will change accordingly. A suitable solution is in need in this field for dealing with the related problems of obtaining the minimum boot-up voltage.

### SUMMARY

Power control methods according to the invention are defined in the independent claims. The dependent claims define preferred embodiments thereof. An embodiment provides a power control method for a system. The power control method can include measuring an internal resistance of a battery of the system, measuring a maximum boot-up current of the system, generating a voltage drop according to the internal resistance and the maximum boot-up current, generating a minimum boot-up voltage according to a predetermined voltage and the voltage drop, and performing a boot-up process using a setting with the minimum boot-up voltage where the battery is charged to at least the minimum boot-up voltage in the boot-up process.

Another embodiment provides a power control method for a system. The power control method can include checking number of times of previous boot-up failures, measuring an internal resistance of a battery of the system, measuring a maximum boot-up current of the system, generating a voltage drop according to the internal resistance and the maximum boot-up current, generating a minimum boot-up voltage according to a predetermined voltage and the voltage drop, generating an adjusted minimum boot-up voltage according to the minimum boot-up voltage and the number of times of previous boot-up failures, and performing a boot-up process using a setting with the adjusted minimum boot-up voltage where the battery is charged to at least the adjusted minimum boot-up voltage in the boot-up process.

Another embodiment provides a power control method for a system. The power control method can include capturing a first minimum boot-up voltage from a non-volatile memory, performing a first boot-up process using a setting with the first minimum boot-up voltage wherein a battery of the system is charged to at least the first minimum boot-up voltage in the first boot-up process, checking whether the first boot-up process fails, increasing the first minimum boot-up voltage to generate a second minimum boot-up voltage if the first boot-up process fails, and performing a second boot-up process using a setting with the second minimum boot-up voltage where the battery of the system is charged to at least the second minimum boot-up voltage in the second boot-up process.

These and other objectives of the present invention will no doubt become obvious to those of ordinary skill in the art after reading the following detailed description of the preferred embodiment that is illustrated in the various figures and drawings.

### BRIEF DESCRIPTION OF THE DRAWINGS

FIG.1 illustrates a diagram of current changing with time in a boot-up process of a system according to an embodiment.
FIG.2 illustrates a flowchart of a power control method for the system according to an embodiment.
FIG.3 illustrates a flowchart of a power control method for the system according to another embodiment.
FIG.4 illustrates a flowchart of a power control method for the system according to another embodiment.
FIG.5 illustrates a flowchart of a power control method for the system according to another embodiment.

### DETAILED DESCRIPTION

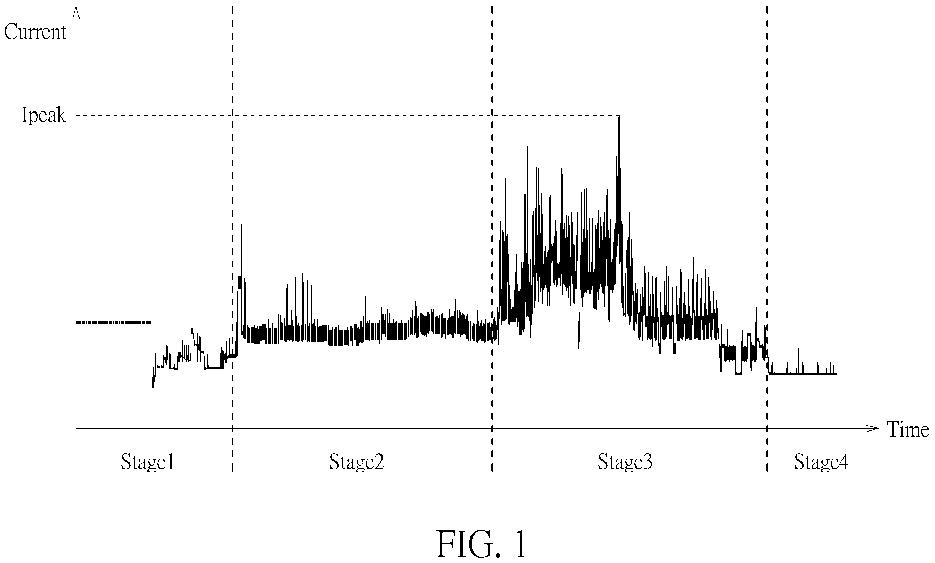

FIG.1 illustrates a diagram of current changing with time in a boot-up process of a system according to an embodiment. In FIG.1, the horizontal axis represents time, and the vertical axis represents current of the boot-up process. The boot-up process can include four stages sequentially. The first stage to the fourth stage can include stage 1: a boot rom stage, stage 2: a preloader stage, stage 3: a kernel stage, and stage 4: a boot complete stage.

The boot rom stage can be a starting stage. The preloader stage can be a little kernel (LK) stage. In the preloader stage, a no-load voltage can be obtained, an internal resistance of a battery (expressed as Rac) can be obtained, and a minimum boot-up voltage (expressed as Vminboot) can be adjusted. In the kernel stage, a peak current (i.e. a maximum current in the boot-up process, expressed as Ipeak) can be observed. In the boot complete stage, the minimum boot-up voltage Vminboot can be stored if the boot-up process is completed. FIG.1 is an example, and embodiments are not limited thereto. For example, in another embodiment, the peak current Ipeak may be observed in another stage.

In the boot-up process, the voltage of the battery in the system may decrease due to IR drop (voltage drop). If the voltage provided by the battery is lower than a threshold, the boot-up process will fail. The threshold may be an undervoltage-lockout (UVLO) voltage (expressed as $V_{UVLO}$) or a predetermined voltage (expressed as V'). The predetermined voltage V' can be equal to or larger than undervoltage-lockout voltage

$V_{UVLO}$. It can expressed as: $V' \geq V_{UVLO}$.

The battery should be charged to at least the minimum boot-up voltage Vminboot in the boot-up process. Otherwise, the boot-up process can not be completed successfully. The minimum boot-up voltage Vminboot may vary when the battery ages and/or the environment changes. For example, when the battery ages, the internal resistance of the battery may increase, and the minimum boot-up voltage Vminboot may increase accordingly. When the temperature decreases, the internal resistance of the battery may increase, and the minimum boot-up voltage Vminboot may increase accordingly. Hence, it is required to adjust the minimum boot-up voltage Vminboot for charging the battery appropriately.

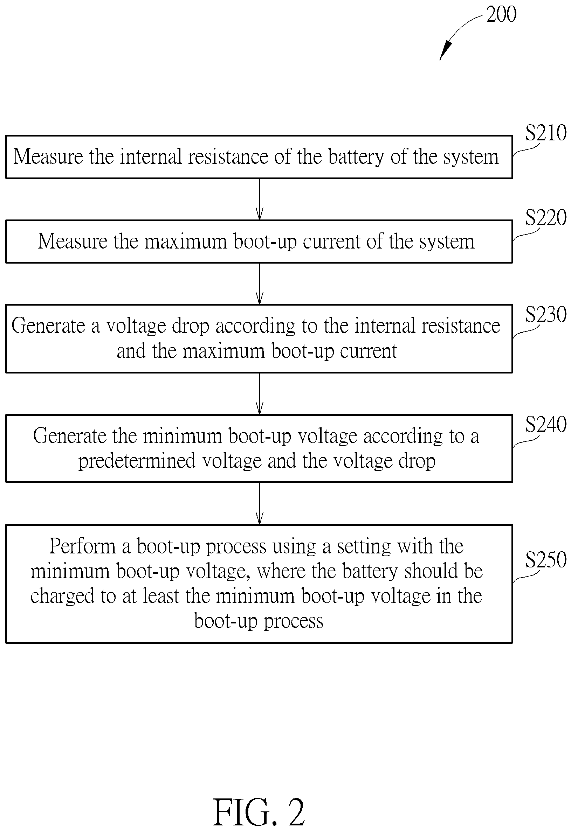

FIG.2 illustrates a flowchart of a power control method 200 for the system according to an embodiment. The power control method 200 can include the following steps.

Step S210: measure the internal resistance of the battery Rac of the system;
Step S220: measure the maximum boot-up current Ipeak of the system;
Step S230: generate a voltage drop (expressed as Vdrop) according to the internal resistance Rac and the maximum boot-up current Ipeak;
Step S240: generate the minimum boot-up voltage Vminboot according to a predetermined voltage V' and the voltage drop Vdrop; and
Step S250: perform a boot-up process using a setting with the minimum boot-up voltage Vminboot, where the battery should be charged to at least the minimum boot-up voltage Vminboot in the boot-up process.

In Step S210, the internal resistance of the battery Rac can be measured. The internal resistance of the battery Rac may increase when the battery ages and/or when the temperature decreases. Since the resistance of the battery Rac may change, the minimum boot-up voltage Vminboot may change accordingly.

In Step S230, the voltage drop Vdrop can be positively related to or equal to the product of the internal resistance Rac and the maximum boot-up current Ipeak, and the product can be expressed as Rac*Ipeak.

In Step S240, the predetermined voltage V' can be equal to or higher than the undervoltage-lockout voltage $V_{UVLO}$ (i.e. $V' \geq V_{UVLO}$), where the system will stop operating if a voltage provided to a power management circuit (a.k.a. PMIC) of the system is lower than the undervoltage-lockout voltage $V_{UVLO}$.

For example, the difference of the minimum boot-up voltage Vminboot and the voltage drop Vdrop should be greater than the predetermined voltage V', so the battery can provided a sufficient voltage for the boot-up process. It can be expressed as the following formula:

$$V' \leq Vminboot - Vdrop \ldots (a).$$

If Vdrop = Rac*Ipeak, the formula (a) can be expressed as the following formula:

$$V' \leq Vminboot - Rac*Ipeak \ldots (b).$$

In the formulas (a) and (b), $V' \geq V_{UVLO}$ as described above.

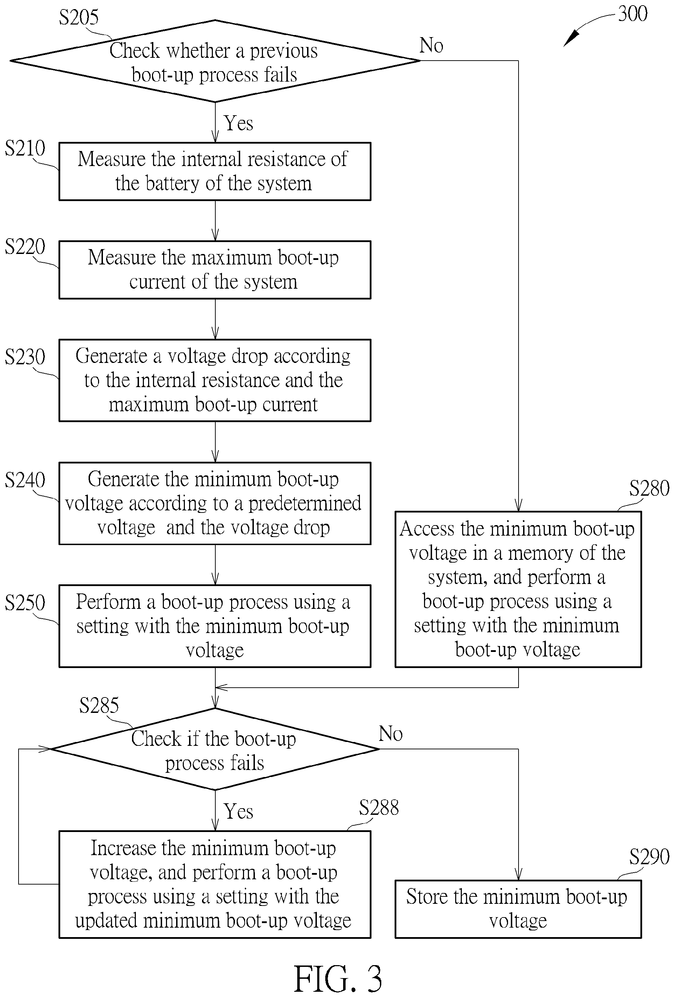

FIG.3 illustrates a flowchart of a power control method 300 for the system according to another embodiment. The power control method 300 can include the following steps.

Step S205: check whether a previous boot-up process fails; if so, enter Step S210; otherwise, enter Step S280;
Step S210: measure the internal resistance of the battery Rac of the system;
Step S220: measure the maximum boot-up current Ipeak of the system;
Step S230: generate a voltage drop Vdrop according to the internal resistance Rac and the maximum boot-up current Ipeak;
Step S240: generate the minimum boot-up voltage Vminboot according to a predetermined voltage V' and the voltage drop Vdrop;
Step S250: perform a boot-up process using a setting with the minimum boot-up voltage Vminboot, where the battery should be charged to at least the minimum boot-up voltage Vminboot in the boot-up process; skip to Step S285;
Step S280: access the minimum boot-up voltage Vminboot in a memory of the system, and perform a boot-up process using a setting with the minimum boot-up voltage Vminboot;
Step S285: check if the boot-up process fails; if so, enter Step S288; otherwise, enter Step S290;
Step S288: increase the minimum boot-up voltage Vminboot, and perform a boot-up process using a setting with the updated minimum boot-up voltage Vminboot; enter Step S285; and
Step S290: store the minimum boot-up voltage Vminboot.

In FIG.3, Step S210 to Step S250 can be similar to that in FIG.2. In Step S205, if the previous boot-up process fails, Step S210 to Step S250 can be performed to update the minimum boot-up voltage Vminboot for the boot-up process. In Step S205, if the previous boot-up process succeeds, Step S280 can be performed to perform the boot-up process using the original minimum boot-up voltage Vminboot.

In Step S285, if the boot-up process fails, it means the minimum boot-up voltage Vminboot in use may be too low, so the voltage provided by the battery may be insufficient. Hence, Step S288 can be performed to increase the minimum boot-up voltage Vminboot. For example, each time the boot-up process fails, the minimum boot-up voltage Vminboot can be increased by a predetermined value such as 0.1 volts. After the minimum boot-up voltage Vminboot is increased, the voltage provided by the battery (e.g. Vminboot - Ipeak*Rac) can be increased to increase the chance of completing the boot-up process successfully.

After Step S288, Step S285 can be performed to check if the boot-up process can be successfully performed. If the boot-up process succeeds, the flow can enter Step S290 to store the minimum boot-up voltage Vminboot at the time, and perform another process after the boot-up process.

In FIG.3, Step S205 can be performed in a preloader stage. If the result of Step S205 is "no" (i.e. the previous boot-up process is completed successfully), Step S280 can be performed in the preloader stage. If the result of Step S205 is "yes" (i.e. the previous boot-up process fails), Step S210 to Step S240 can be performed in a little kernel (LK) stage. A kernel stage can follow the little kernel stage, and a boot complete stage can follow the kernel stage. Step S250, Step S288 and Step S290 can be performed in the boot complete stage.

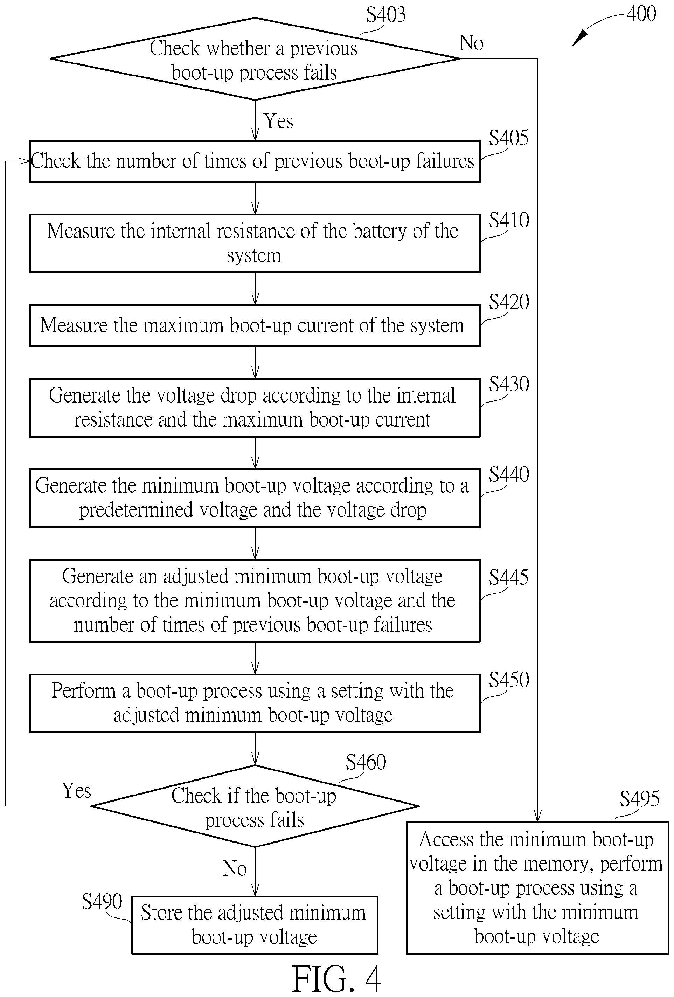

FIG.4 illustrates a flowchart of a power control method 400 for the system according to another embodiment. The power control method 400 can include the following steps.

Step S403: check whether a previous boot-up process fails; if so, enter Step S405; otherwise, enter Step S495;
Step S405: check the number of times of previous boot-up failures;
Step S410: measure the internal resistance of the battery Rac of the system;
Step S420: measure the maximum boot-up current Ipeak of the system;
Step S430: generate the voltage drop Vdrop according to the internal resistance Rac and the maximum boot-up current Ipeak;
Step S440: generate the minimum boot-up voltage Vminboot according to a predetermined voltage V' and the voltage drop Vdrop;
Step S445: generate an adjusted minimum boot-up voltage Vminboot' according to the minimum boot-up voltage Vminboot and the number of times of previous boot-up failures;
Step S450: perform a boot-up process using a setting with the adjusted minimum boot-up voltage Vminboot', where the battery should be charged to at least the adjusted minimum boot-up voltage Vminboot' in the boot-up process;
Step S460: check if the boot-up process fails, if so, enter Step S405; otherwise, enter Step S490; and
Step S490: store the adjusted minimum boot-up voltage Vminboot'.
Step S495: access the minimum boot-up voltage Vminboot in the memory, perform a boot-up process using a setting with the minimum boot-up voltage Vminboot.

In Step S405, the number of times of previous boot-up failures can be recorded. The number of times of previous boot-up failures can be stored in a non-volatile memory of the system, such as a register or a plurality of registers in a power management circuit (PMIC).

In FIG.4, Step S410 to Step S440 can be similar to Step S210 to Step S240 respectively. In Step S430, the voltage drop Vdrop can be positively related to or equal to the product of the internal resistance Rac and the maximum boot-up current Ipeak (i.e. the product can be Rac*Ipeak).

In Step S440, the predetermined voltage V' can be equal to or higher than an undervoltage-lockout voltage $V_{UVLO}$ (i.e. V' $\geq V_{UVLO}$), where the system will stop operating when a voltage provided to a power management circuit (PMIC) is lower than the undervoltage-lockout voltage $V_{UVLO}$.

In Step S445, the adjusted minimum boot-up voltage Vminboot' can be generated by adding a value to the minimum boot-up voltage Vminboot obtained in Step S440, and the value can be larger if the number of times of previous boot-up failures is greater. For example, if the number of times of previous boot-up failures is one, the adjusted minimum boot-up voltage Vminboot' can be generated by adding 0.1 volts to the minimum boot-up voltage Vminboot obtained in Step S440. If the number of times of previous boot-up failures is two, the adjusted minimum boot-up voltage Vminboot' can be generated by adding 0.2 volts to the minimum boot-up voltage Vminboot obtained in Step S440.

Step S403 can be perform in a preloader stage following a bootrom stage. Step S405 to Step S450 can be performed in a little kernel (LK) stage following the preloader stage. Step S460 can be performed in a kernel stage following the little kernel (LK) stage. Step S490 can be performed in a boot complete state following the kernel stage.

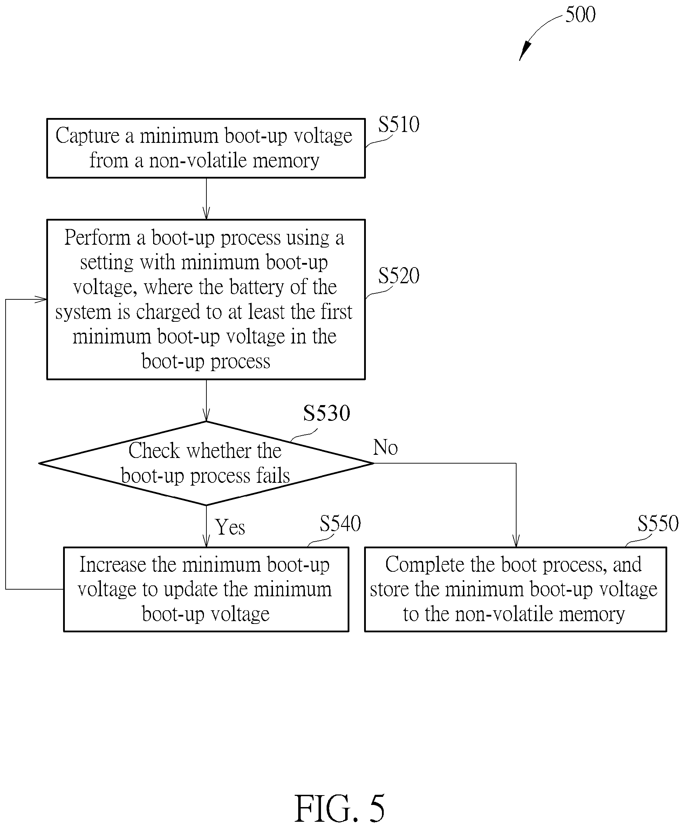

FIG.5 illustrates s a flowchart of a power control method 500 for the system according to another embodiment. The power control method 500 can include the following steps.

Step S510: capture a minimum boot-up voltage Vminboot from a non-volatile memory;
Step S520: perform a boot-up process using a setting with minimum boot-up voltage Vminboot, where the battery of the system is charged to at least the first minimum boot-up voltage Vminboot in the boot-up process;
Step S530: check whether the boot-up process fails; if so, enter Step S540; otherwise, enter Step S550;
Step S540: increase the minimum boot-up voltage Vminboot to update the minimum boot-up voltage Vminboot; enter Step S520; and

Step S550: complete the boot-up process, and store the minimum boot-up voltage Vminboot to the non-volatile memory.

In FIG.5, when the boot-up process fails, the minimum boot-up voltage Vminboot can be increased, and the flow can be performed recursively till the boot-up process is completed. In other words, if the boot-up process fails, the minimum boot-up voltage Vminboot can be increased till the boot-up process is completed successfully.

In an embodiment, each time the boot-up process fails, the minimum boot-up voltage Vminboot can be increased by a fix voltage. For example, when the boot-up process fails for the first time, the minimum boot-up voltage Vminboot can be increased by a first value to update the minimum boot-up voltage Vminboot, and when the boot-up process fails for the second time, the updated minimum boot-up voltage Vminboot can be increased by the first value to further update the minimum boot-up voltage Vminboot. In other words, the difference between a first minimum boot-up voltage and a second minimum boot-up voltage can be equal to the difference between the second minimum boot-up voltage and a third minimum boot-up voltage.

In another embodiment, when the boot-up process fails for a plurality of times, the minimum boot-up voltage Vminboot can be increased by different voltages. For example, when the boot-up process fails for the first time, the minimum boot-up voltage Vminboot can be increased by a first value to update the minimum boot-up voltage Vminboot, and when the boot-up process fails for the second time, the updated minimum boot-up voltage Vminboot can be increased by a second value to further update the minimum boot-up voltage Vminboot. The first value and the second value can be different. In other words, the difference between a first minimum boot-up voltage and a second minimum boot-up voltage is not equal to the difference between the second minimum boot-up voltage and a third minimum boot-up voltage. For example, the second value can be greater than the first value. In another example, the second value can be smaller than the first value.

According to the power control methods 200, 300, 400 and 500, the minimum boot-up voltage Vminboot can be calculated and adjusted dynamically. The battery should be charged at least to the adjusted minimum boot-up voltage Vminboot, and a voltage provided by the battery (e.g. Vminboot -Ipeak*Rac) will be sufficient for the boot-up process to effectively avoid the failure of the boot-up process.

Those skilled in the art will readily observe that numerous modifications and alterations of the device and method may be made while retaining the teachings of the invention. Accordingly, the above disclosure should be construed as limited only by the metes and bounds of the appended claims.

**Claims**

1. A power control method for a system, comprising:

   measuring an internal resistance of a battery of the system (S210);
   measuring a maximum boot-up current of the system (S220);
   generating a voltage drop according to the internal resistance and the maximum boot-up current (S230);
   generating a minimum boot-up voltage according to a predetermined voltage and the voltage drop (S240); and
   performing a boot-up process using a setting with the minimum boot-up voltage, wherein the battery is charged to at least the minimum boot-up voltage in the boot-up process (S250).

2. A power control method for a system, comprising:

   checking number of times of previous boot-up failures (S405);
   measuring an internal resistance of a battery of the system (S410);
   measuring a maximum boot-up current of the system (S420);
   generating a voltage drop according to the internal resistance and the maximum boot-up current (S430);
   generating a minimum boot-up voltage according to a predetermined voltage and the voltage drop (S440);
   generating an adjusted minimum boot-up voltage according to the minimum boot-up voltage and the number of times of previous boot-up failures (S445); and
   performing a boot-up process using a setting with the adjusted minimum boot-up voltage (S450), wherein the battery is charged to at least the adjusted minimum boot-up voltage in the boot-up process.

3. The power control method of claim 2, wherein the adjusted minimum boot-up voltage is generated by adding a value to the minimum boot-up voltage, and the value is larger if the number of times of previous boot-up failures is greater.

4. The power control method of any one of claims 1 to 3, wherein the predetermined voltage is equal to an undervoltage-lockout voltage, wherein the system stops operating when a voltage provided to a power management circuit is lower than the undervoltage-lockout voltage.

5. The power control method of any one of claims 1 to 3, wherein the predetermined voltage is higher than an undervoltage-lockout voltage, wherein the system stops operating when a voltage provided to a power management circuit is lower than the undervoltage-lockout voltage.

6. The power control method of any one of claims 1 to 5, wherein the voltage drop is positively related to a product of the internal resistance and the maximum boot-up current.

7. The power control method of any one of claims 1 to 5, wherein the voltage drop is equal to a product of the internal resistance and the maximum boot-up current.

8. The power control method of any one of claims 1 to 7, further comprising:

checking whether a previous boot-up process fails (S205);
wherein the internal resistance of the battery of the system is measured if the previous boot-up process fails (S220).

9. The power control method of any one of claims 1 to 8, further comprising:

checking if the boot-up process fails (S285); and
increasing the minimum boot-up voltage if the boot-up process fails (S288).

10. The power control method of any one of claims 2, 3, 8, and of claim 9 being dependent on at least claim 8, wherein the number of times of previous boot-up failures is stored in a non-volatile memory (S490).

11. A power control method for a system, comprising:

capturing a first minimum boot-up voltage from a non-volatile memory (S510);
performing a first boot-up process using a setting with the first minimum boot-up voltage, wherein a battery of the system is charged to at least the first minimum boot-up voltage in the first boot-up process (S520);
checking whether the first boot-up process fails (S530);
increasing the first minimum boot-up voltage to generate a second minimum boot-up voltage if the first boot-up process fails (S540); and
performing a second boot-up process using a setting with the second minimum boot-up voltage, wherein the battery of the system is charged to at least the second minimum boot-up voltage in the second boot-up process (S520).

12. The power control method of claim 11, further comprising:

checking whether the second boot-up process fails (S530);
increasing the second minimum boot-up voltage to generate a third minimum boot-up voltage if the second boot-up process fails (S540); and
performing a third boot-up process using a setting with the third minimum boot-up voltage, wherein the battery of the system is charged to at least the third minimum boot-up voltage in the third boot-up process (S520);
wherein a difference between the first minimum boot-up voltage and the second minimum boot-up voltage is equal to a difference between the second minimum boot-up voltage and the third minimum boot-up voltage.

13. The power control method of claim 11, further comprising:

checking whether the second boot-up process fails (S530);
increasing the second minimum boot-up voltage to generate a third minimum boot-up voltage if the second boot-up process fails (S540); and
performing a third boot-up process using a setting with the third minimum boot-up voltage, wherein the battery of the system is charged to at least the third minimum boot-up voltage in the third boot-up process (S520);
wherein a difference between the first minimum boot-up voltage and the second minimum boot-up voltage is not equal to a difference between the second minimum boot-up voltage and the third minimum boot-up voltage.

FIG. 1

200

| Measure the internal resistance of the battery of the system | S210 |

↓

| Measure the maximum boot-up current of the system | S220 |

↓

| Generate a voltage drop according to the internal resistance and the maximum boot-up current | S230 |

↓

| Generate the minimum boot-up voltage according to a predetermined voltage and the voltage drop | S240 |

↓

| Perform a boot-up process using a setting with the minimum boot-up voltage, where the battery should be charged to at least the minimum boot-up voltage in the boot-up process | S250 |

# FIG. 2

S205

Check whether a previous boot-up process fails — No

Yes

S210  Measure the internal resistance of the battery of the system

S220  Measure the maximum boot-up current of the system

S230  Generate a voltage drop according to the internal resistance and the maximum boot-up current

S240  Generate the minimum boot-up voltage according to a predetermined voltage and the voltage drop

S250  Perform a boot-up process using a setting with the minimum boot-up voltage

S280  Access the minimum boot-up voltage in a memory of the system, and perform a boot-up process using a setting with the minimum boot-up voltage

300

S285

Check if the boot-up process fails — No

Yes

S288  Increase the minimum boot-up voltage, and perform a boot-up process using a setting with the updated minimum boot-up voltage

S290  Store the minimum boot-up voltage

FIG. 3

S403

Check whether a previous boot-up process fails — No

400

Yes

S405
Check the number of times of previous boot-up failures

S410
Measure the internal resistance of the battery of the system

S420
Measure the maximum boot-up current of the system

S430
Generate the voltage drop according to the internal resistance and the maximum boot-up current

S440
Generate the minimum boot-up voltage according to a predetermined voltage and the voltage drop

S445
Generate an adjusted minimum boot-up voltage according to the minimum boot-up voltage and the number of times of previous boot-up failures

S450
Perform a boot-up process using a setting with the adjusted minimum boot-up voltage

S460
Yes — Check if the boot-up process fails

S495
Access the minimum boot-up voltage in the memory, perform a boot-up process using a setting with the minimum boot-up voltage

No

S490
Store the adjusted minimum boot-up voltage

FIG. 4

500

Capture a minimum boot-up voltage
from a non-volatile memory
S510

Perform a boot-up process using a
setting with minimum boot-up
voltage, where the battery of the
system is charged to at least the first
minimum boot-up voltage in the
boot-up process
S520

Check whether the
boot-up process fails
S530

No

Yes
S540

Increase the minimum boot-up
voltage to update the minimum
boot-up voltage

S550

Complete the boot process, and
store the minimum boot-up voltage
to the non-volatile memory

FIG. 5

Europäisches
Patentamt

European
Patent Office

Office européen
des brevets

# EUROPEAN SEARCH REPORT

**Application Number**

EP 25 15 2797

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/294197 A1 (THOMPSON RICHARD C [US] ET AL) 6 October 2016 (2016-10-06) <br> * abstract * <br> * paragraph [0032] - paragraph [0037]; figures 1, 3 * <br> * paragraph [0043] * <br> ----- | 1-13 | INV. <br> G06F1/28 <br> G06F1/30 <br> G06F1/3212 <br> G06F11/00 <br> G06F11/22 <br> G01R31/389 |
| A | US 2017/357310 A1 (HOVIS WILLIAM PAUL [US] ET AL) 14 December 2017 (2017-12-14) <br> * abstract * <br> * paragraph [0030] - paragraph [0035]; figures 1, 3, 7, 8 * <br> ----- | 1-13 | |
| A | WO 2020/005196 A1 (GOOGLE LLC [US]) 2 January 2020 (2020-01-02) <br> * abstract * <br> * paragraph [0028] - paragraph [0033]; figure 5 * <br> ----- | 1-13 | |

| | |
|---|---|
| | **TECHNICAL FIELDS SEARCHED (IPC)** |
| | G06F <br> G01R |

The present search report has been drawn up for all claims

| Place of search | Date of completion of the search | Examiner |
|---|---|---|
| The Hague | 12 June 2025 | Reis Rodrigues, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...............................................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 15 2797

This annex lists the patent family members relating to the patent documents cited in the above-mentioned European search report.
The members are as contained in the European Patent Office EDP file on
The European Patent Office is in no way liable for these particulars which are merely given for the purpose of information.

12-06-2025

| Patent document cited in search report | Publication date | Patent family member(s) | Publication date |
|---|---|---|---|
| US 2016294197 A1 | 06-10-2016 | NONE | |
| US 2017357310 A1 | 14-12-2017 | US 2017357310 A1 | 14-12-2017 |
| | | WO 2017213973 A1 | 14-12-2017 |
| WO 2020005196 A1 | 02-01-2020 | CN 111602308 A | 28-08-2020 |
| | | DE 112018006292 T5 | 15-10-2020 |
| | | EP 3711136 A1 | 23-09-2020 |
| | | US 2020174080 A1 | 04-06-2020 |
| | | US 2022099747 A1 | 31-03-2022 |
| | | WO 2020005196 A1 | 02-01-2020 |

EPO FORM P0459

For more details about this annex : see Official Journal of the European Patent Office, No. 12/82